# EUROPEAN PATENT APPLICATION

(11) **EP 3 098 857 A1**
(43) Date of publication of application: **30.11.2016**
(21) Application number: 16165853.9
(22) Date of filing: 18.04.2016
(51) Int. Cl.: H01L 29/423, H01L 29/66, H01L 29/78, H01L 29/10

(54) **FIELD-EFFECT TRANSISTORS WITH BODY DROPDOWNS**

(30) Priority: 26.05.2015 US 201514721648
(71) Applicant: NXP B.V., 5656 AG Eindhoven (NL)
(72) Inventor: BOOS, Priscilla, 5656 AG Eindhoven (NL); MELS, Arjan, 5656 AG Eindhoven (NL)
(74) Representative: Crawford, Andrew

(57) **Abstract**

A field-effect transistor (FET) includes, a first drain, a second drain, a body and a gate region. The gate region has a length, and is configured and arranged to create, in response to a gate voltage, a channel that is in the body, between the first and second drains, and along the length of the gate region. A plurality of body dropdowns are located in the gate region and are spaced along a width of the gate region. Each of the body dropdowns are configured and arranged to provide an electrical contact to the body for biasing purposes.

## Description

### OVERVIEW

Aspects of various embodiments are directed to integrated circuit apparatuses and more particularly to apparatuses and methods of using a field-effect transistors (FETs) with body dropdowns.

A metal-oxide semiconductor (MOS) FETs can be used for a variety of different applications. In some instances, the FET can be constructed using various complementary metal-oxide-semiconductor (CMOS) technology. In various instances, a voltage provided on one or both sides of the FET can include a high voltage, such as 20-50 volts (V). For example, with universal serial bus (USB) power delivery (USB-PD), a device may be powered using a USB-compatible interface that provides power for charging devices. In such instances, relatively high voltages can be provided for charging purposes.

These and other matters have presented challenges to efficiencies of FET implementations, for a variety of applications.

### SUMMARY

Various example embodiments are directed to FETs and their implementation. According to an example embodiment, an apparatus includes field-effect transistor (FET) with a first drain, a second drain, a body and a gate region. The gate region has a length, and is configured and arranged to create, in response to a gate voltage, a channel that is in the body, between the first and second drains, and along the length of the gate region. A plurality of body dropdowns are located in the gate region and are spaced along a width of the gate region. Each of the body dropdowns are configured and arranged to provide an electrical contact to the body for biasing purposes.

According to embodiments, a device includes a field-effect transistor (FET) that has a substrate material, a body at a surface of the substrate material and of a first doping type, a first drain at the surface of the substrate material and of a second doping type, that is different from the first doping type, a second drain at the surface of the substrate material and of the second doping type, and the gate region. The gate region includes a gate that is located at the surface of the substrate material, that extends along a length of the gate region, and that is configured and arranged to create, in response to a gate voltage, a channel that is in the body, between the first and second drain regions, and along the length of the gate region. An electrically insulating layer is located between the body and the gate. A plurality of body dropdowns are located in the gate region and spaced along a width of the gate region. Each of the plurality of body dropdowns is electrically isolated from the gate and configured and arranged to provide an electrical contact to the body.

According to embodiments, a device includes a field-effect transistor (FET) with a well of a first doping type, a first drain in the well region and of a second doping type, that is different from the first doping type, a second drain in the well region and of the second doping type, a body in the well and of the first doping type, and the gate region in the well. The gate region has a gate that extends along a length of the gate region, and that is configured and arranged to create, in response to a gate voltage, a channel that is in the body and that is configured to conduct current between the first and the second drains, and along the length of the gate region. An electrically insulating layer is located between the body and the gate. A plurality of body dropdowns are spaced along a width of the gate region. Each of the plurality of body dropdowns is electrically isolated from the gate and configured and arranged to provide an electrical contact to the body.

The above discussion/summary is not intended to describe each embodiment or every implementation of the present disclosure. The figures and detailed description that follow also exemplify various embodiments.

### DESCRIPTION OF THE DRAWINGS

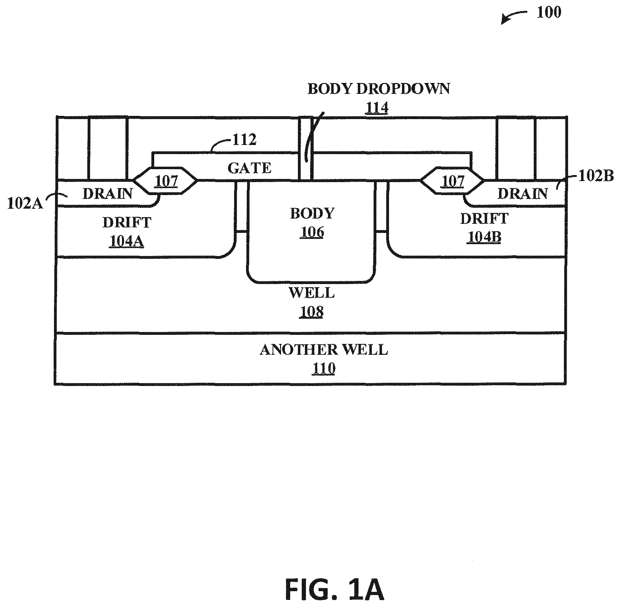

Various example embodiments may be more completely understood in consideration of the following detailed description in connection with the accompanying drawings, in which: FIG. 1A shows a block diagram of an example FET according to various embodiments of the present disclosure;
FIG. 1B shows an enlarged view of the body dropdown area of the FET of FIG. 1A according to various embodiments of the present disclosure;
FIG. 2 shows a top view and cross sectional view of a FET according to various embodiments of the present disclosure; and
FIG. 3 shows a flow diagram of an example process for forming a FET according to various embodiments of the present disclosure.

While various embodiments discussed herein are amenable to modifications and alternative forms, aspects thereof have been shown by way of example in the drawings and will be described in detail. It should be understood, however, that the intention is not to limit the invention to the particular embodiments described. On the contrary, the intention is to cover all modifications, equivalents, and alternatives falling within the scope of the disclosure including aspects defined in the claims. In addition, the term "example" as used throughout this application is only by way of illustration, and not limitation.

### DETAILED DESCRIPTION

Aspects of the present disclosure are believed to be applicable to a variety of different types of apparatuses, systems and methods involving device having a FET with a plurality of body dropdowns that are spaced along a length of a gate region and that provide an electrical contact to a body region. In certain implementations, aspects of the present disclosure have been shown to be beneficial when used in the context of an apparatus that may apply voltages (e.g., high voltages of 20V-50V) on either side of the FET. In some embodiments, a bias circuit can provide a bias voltage for the body using body dropdowns. These and other aspects can be implemented to address challenges, including those discussed in the background above. While not necessarily so limited, various aspects may be appreciated through a discussion of examples using such exemplary contexts.

In accordance with a number of embodiments, a power MOSFET can be used to control current flow between two sides of the FET. For ease of discussion, when the term FET is used, and unless otherwise stated, it is understood to include a power MOSFET. In various instances, the FET can be designed for applications in which a high voltage can be provided to either side of the FET. For instance, the FET can be designed for use as a bidirectional switch in which power can be provided from either direction. Various embodiments are directed toward biasing of the body of the FET at locations that are proximate to a gate region of the FET. Biasing of the body can be particularly useful for power MOSFET structures that can contain an inherent parasitic N-P-N (or P-N-P) bipolar transistor formed between the two internal junctions between the drain/source regions and the gate region. A junction of the parasitic bipolar transistor can be turned on during breakdown, resulting in unwanted current flow. Biasing the body can be used to suppress the effect of the parasitic bipolar transistor. Moreover, embodiments are directed toward body dropdowns that allow for the biasing of the body to be performed at locations within the gate region itself can be particularly useful.

As discussed herein, the term "gate region" refers a region of the FET that can include the gate, gate contacts, body dropdowns, and a portion of the body in which the channel forms. The term "gate" can refer to a conductive (e.g., metalized or polysilicon) layer that controls the formation of the channel in response to a voltage that is applied through one or more gate contacts. The gate contacts can be configured to connect the gate to other layers of the semiconductor device, e.g., through wiring layer(s). The terms "drain region" refers to a region of the FET that can include the drain, drain contacts, and drain extensions. The term "drain" refers to a portion of the semiconductor material that is doped to be conductive and to form a junction with the body. Unless otherwise stated, the drain region(s) can overlap with the gate region, e.g., where the gate overlaps with the drain extensions.

Consistent with embodiments, a bias circuit can be configured to generate the biasing voltage based upon on a voltage present at one of drain/source terminals of the FET. As the FETs can be bidirectional, either terminal can be considered a drain or source. Accordingly and for ease of discussion, the source/drain terminals of the FETs are both referred to as a drain. The application of a bias voltage to the body, within the gate region of the FET, can be particularly useful for improving the breakdown voltage of the FET caused by parasitic bipolar turn on. Such an application of a bias voltage can also be useful for reducing leakage and/or lowering the channel resistance of the FET.

In some instances, the FET can be configured with extended drain regions that improve breakdown characteristics and allow for the use of relatively high voltages on a drain. However, a corresponding source may not be able to handle high voltages, which can be particularly problematic for power MOSFET structures with low on resistances and/or for bidirectional applications. To handle high voltages on both sides of the FET, two FETs can be used with their sources and gates tied together (e.g., two separate transistors back to back), at the cost of additional the area, as compared to a single transistor. In some implementations, a FET can include a drain extension region with two gates and two sources, resulting in two distinct channels. This may require that the voltages for each of the two gates be separately controlled to relative to the respective sources. The additional logic used for separate control can increase the complexity of the circuitry for controlling the gate.

According to various example embodiments, aspects of the present disclosure are directed toward a FET that is configured to bias the body using a plurality of body dropdowns are located along a width of a gate region through which the body is contacted. The body dropdowns can provide an electrical contact to the body that is very close to the drains and to the channel formed when the FET is active. A bias circuit of the device can be configured to generate the bias voltage and to provide the bias voltage for the body dropdowns. For instance, the bias circuit can be configured to generate the bias voltage based on a voltage provided to the either of the drain regions of the FET. According to some embodiments, providing the bias voltage to the locations within the gate region can be useful for reducing and/or minimize gate region breakdown from high voltages for either side of the FET (e.g., due to the proximity to the gate and drains). This can be particularly useful for a FET with a small size and a low on-resistance (e.g., relative to two FETs tied together), as the FET uses a single channel and has a good body connection that is proximate to the drains and to the channel. For example, some embodiments allow for the channel area and resistance to be halved, as compared to two comparable FETs tied together.

In various embodiments, the use of body contacts within the gate region and through the gate can result in a smaller sized FET, as compared to providing body contacts at a location that is outside of the drain and gate regions. For instance, body contacts can be brought up to the surface in a body contact region outside of the FET. Moreover, this additional body contact region can increase the amount of space used for the FET, as compared to using body dropdowns located in the gate region without a corresponding additional body contact region.

Turning now to the figures, FIG. 1A shows a block diagram of an example of a FET 100, as may be implemented in accordance with one or more embodiments of the present disclosure. As illustrated by FIG. 1A, various FET embodiments include a well 108, first and second drains 102A, 102B, a body 106, and a gate 112. A FET, in various embodiments, can include, but is not necessarily limited to, a metal-oxide-semiconductor FET (MOSFET), a p-type metal-oxide-semiconductor FET (PMOS), and an n-type metal-oxide-semiconductor FET (NMOS).

A FET, in accordance with embodiments of the present disclosure, can be bidirectional and/or symmetrical, allowing for relatively high voltages to be present on either side of the gate 112. The FET can be symmetrical with respect to the drain regions as each region can include a similarly-shaped drift region. These two drift regions can be similar to the drain of an asymmetrical device, which may not have a drift region for the source (or may have a differently-shaped drift region for the source). Each of the first and second drains 102A, 102B, can be a drain or a source due to the symmetry of the regions 102A, 102B. Thereby, convention can allow for one of the drains to be considered a source and the other drain to be considered a drain for a particular use/applied voltage. In certain embodiments, a FET can be asymmetrical with respect to the drains. For instance, a FET can be designed with different voltage tolerances on respective drains by varying parameters such as the size and shape of an extended drain region (if any) for each drain.

The body 106, as illustrated by FIG. 1A, can separate the first and the second drains 102A, 102B. The body 106 can be of a different donor type than the first and the second drains 102A, 102B so that the channel can be formed between the drains by controlling the gate voltage of the FET.

The first and second drains 102A, 102B are within the well 108 and can include drain extensions (or drift regions) 104A, 104B that can be useful for improving breakdown voltages for the corresponding drain. The well 108 is of a first donor type (*e*.*g*., p-type or n-type). In accordance with various embodiments, the FET 100 can include a second well 110. The well 108 can be within the second well 110 and the second well 110 can be of a second donor type that is different than the first donor type. This can be particularly useful for isolating the well 108 from the substrate.

The first and second drains 102A, 102B can of the second donor type. The second donor type is different than the first donor type, in various embodiments. A donor type, as used herein, can include n-type or p-type. For example, in accordance with some embodiments, the first donor type can include a p-type and the second donor type can include an n-type. In such embodiments, the FET 100 can be an n-type (NMOS) FET. It is understood that the FET 100 can also be configured as a p-type (PMOS) FET.

The gate 112 can be in the well 108. As used herein, the length of the gate 112 refers, in general terms, to the distance between the drains 102A and 102B and the width refers to a distance that extends perpendicular, or generally perpendicular to the length. The skilled person will appreciate that the length of the gate may also be called the "gate length". The skilled person will also appreciate that the device may exhibit an "effective gate length" which is related to but may deviate from the physical length of the gate, or gate length, as just defined. The gate region, in various embodiments, includes a plurality of body dropdowns 114 that are electrically insulated from the gate 112. The body dropdowns 114 can be spaced along the width of the gate region and can be electrically connected to the body 106.

In certain embodiments the body dropdowns may be equally spaced across the width of the gate. The particular size of the spacing can be adjusted based upon the desired breakdown voltage, on resistance as well as upon other device parameters, such as the doping concentration and type, component size (e.g., gate length, drift region size), and device structure.

In various embodiments, the spacing between different consecutive the body dropdowns can vary along the width of the gate region. For example, the spacing may vary to allow for larger channel segments in areas where the spacing is larger. In some instances, the spacing can vary according to differences between the size and structure of the body dropdowns. For instance, the size of the diffusion region and/or of the conductive portion of the via can be varied between different types of body dropdowns. The spacing between these different types of body dropdowns can then be varied accordingly. Consistent with embodiments, the patterning of the dropdowns can be configured so that near the center of the gate there is an increased dropdown density, dropdown size, or both, relative to the corresponding density or dropdown size near the edges of the gate. This can be particularly useful for situations where the bias connection of the body along the edges of the FET is better (e.g., due to bias connections outside of the gate area), and thus, less body dropdowns are necessary along the edges.

Certain embodiments also allow for different patterning of the body dropdowns (e.g., as opposed to a single line through the middle of the gate region). For example, there can be multiple lines, or staggering of the body dropdowns and the corresponding vias. This can be particularly useful for large gate lengths where multiple dropdowns fit within the length, e.g., to keep the on resistance of the FET as low as possible.

In some embodiments it can be beneficial to have a multiple vias within a single opening of the gate. For example, two or more vias can be located very close to one another and along the length or width of the gate, or both the length and width. This may be particularly useful for situations where, possibly due to a manufacturing defect, one of the contacts is not properly formed. The presence of another via in close proximity will still allow for an ohmic connection to the body in this location. The use of multiple closely located vias can also be useful for lowering the effective resistance of the connection to the body at those locations.

Consistent with embodiments, FETs on the same integrated circuit (IC) substrate can have different body dropdown solutions based upon the different requirements for each of the FETs. The differences might include, for example, via size, contact construction, body dropdown pattern, body dropdown density or spacing, and combinations thereof.

In various embodiments, a bias circuit can be configured to provide a bias voltage to the body drop downs and to the electrical contact the dropdowns provide to the body 106. More particularly, the bias voltage provided can be based on a voltage present on one of drains 102A, 102B. By applying the bias voltage to the body using dropdowns in the gate region (e.g., as opposed to using a breakout/extension of the body outside of the gate area) the operating characteristics of the FET 100 can be improved. This can be particularly useful for suppressing the effect of the parasitic bipolar transistor in response to the bias voltage, reducing on-resistance, reducing leakage of the FET, or combinations thereof. For example, a high voltage on a drain can cause electron and hole generation in portions of the FET and the holes can flow current to the body 106 via a certain body resistance. The current can raise the potential of the body 106 that is a p-type and forward biases the body 106. In some instances, the forward biasing can be enough to turn on the parasitic bipolar transistor, leading to premature breakdown. Similarly, a body 106 of an n-type can be forward biased.

To suppress parasitic bipolar transistor turn on, the bias voltage provided to the electrical contact of the body can be based on a voltage provided the particular drain region that has the lowest or the highest voltage relative to the other drain region. For example, for an NMOS FET, the bias voltage can be generated based on the lower of the voltages at each of the first or second drain 102A, 102B. For a PMOS FET, the bias voltage can be generated based on the higher of the voltages at each of the drain regions. For instance, the bias voltage can be set to a value that closely tracks with the voltage at the drain region. It is understood that the precise bias voltage can be set to a value sufficient to suppress the effect of the parasitic bipolar transistor, and that this value can vary according to the specific configuration of the FET. The bias voltage can be provided to the body using the body drop downs. In this manner, the body dropdowns 114 can provide an electrical contact to the body 106 that is useful for biasing the body proximate to the channel and to the drains (e.g., to suppress parasitic effects and leakage).

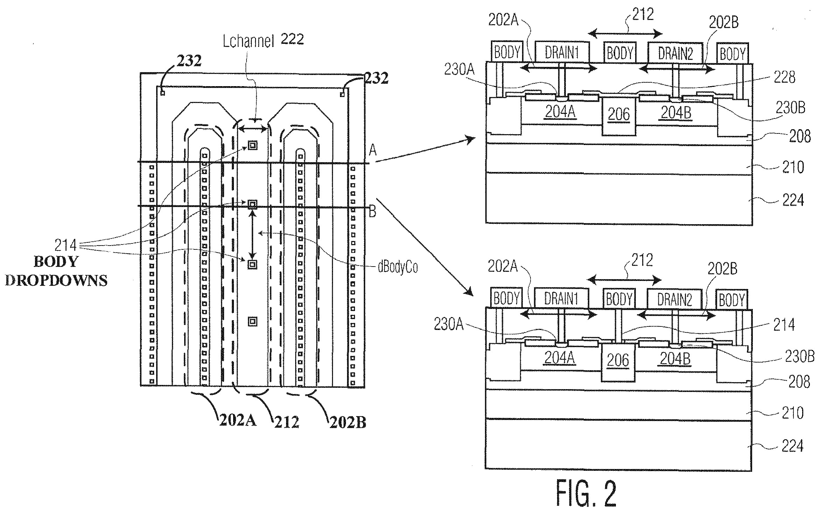

The amount of and distance between the body dropdowns 114 *(e.g.,* referred to as dBodyCo in Figure 2) may determine how the voltage (e.g., how effectively) can be maintained in the body 106 under influence of, for example, the mentioned electron and hole generation. The successful maintenance of the body voltage can, for instance, be used for suppression of the parasitic bipolar transistor turn on.

Due to the body dropdowns 114, in accordance with some embodiments, the channel created by the gate 112 can be segmented by the body dropdowns 114. For instance, the material used to create a contact for the body dropdowns 114 can dissuade the body region from inverting and, thereby, a channel may not form at the location of the body dropdowns 114 in the body 106. That is, the channel created can have portions of the channel that are segmented by the body dropdowns 114. As used herein, a segmented channel includes conductive portions that form in spaces between the plurality of body dropdowns 114. The conductive portions are separated by, or segmented by, each of the plurality of body dropdowns 114, where no conductive channel forms. Somewhat surprisingly, the segmentation of the channel has been found to have a relatively small effect on the overall resistance of the channel. This is relevant to various applications because the current capability of the FET is based upon the channel size. If the body dropdowns take, for example, 1/10 of the channel size, a corresponding decrease in current flow can be expected. Experimental results, however, indicate that the actual current flow reduction is less than expected.

In various embodiments, the FET 100 can include a first drift region 104A and a second drift region 104B. The first drain 102A can be in the first drift region 104A and the second drain 102B can be in the second drift region 104B. The well 108 can, for example, isolate the first drift region 104A from the second drift region 104B. A voltage *(e.g.,* from the drains 102A, 102B) can drop across the first and second drift region 104A, 104B so that the voltage seen by the well is lower, and thereby allowing the FET 100 to handle higher voltages on each side of the FET 100 without and/or while avoiding breakdown as compared to a FET with a drain and source.

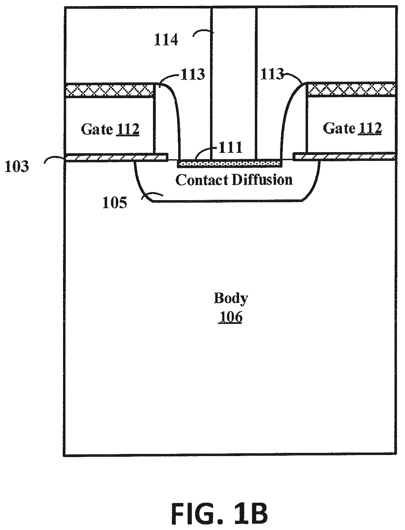

In various embodiments, the FET 100 can include an electrically insulating layer between the gate 112 and the body 106. The electrically insulating layer can include an oxide layer and the gate 112 can be a metal or polysilicon layer. In some embodiments, the electrically insulating layer can include two or more layers, with one layer being thicker than the other. For instance, FIG.1A illustrates a first electrically insulating layer 107 between the gate and the drift region 104A that is thicker than a second electrically insulating layer *(e.g.,* 103 illustrated by Figure 1B) between the gate 112 and the body 106. Although the present embodiment illustrated by FIG. 1A-1B illustrates two electrically insulating layers, embodiments in accordance with the present disclosure are not so limited and can include greater or fewer electrically insulating layers.

FIG. 1B illustrates an enlarged view of the body dropdown area of the FET of FIG. 1A, in accordance with one or more embodiments of the present disclosure. As illustrated by FIG. 1B, an electrically insulating layer 103 can isolate the gate 112 from the body 106. In various embodiments, the electrically insulating layer 103 can also extend over a portion of each of the first and second drains *(e.g.,* as shown by the electrically insulating layer 107 illustrated by FIG. 1A).

As further illustrated by FIG.1B, a layer of silicide 111 can be located in the opening of the body dropdown 114. The silicide can form an electrical contact for the body dropdown 114 to contact the body 106. In some embodiments, a contact diffusion region 105 can be formed between the layer of silicide 111 and the body 106. For instance, the contact diffusion region 105 can be doped at using the same donor type, but at a higher level, as the body 106, and can be configured to improve an electrical contact to the body 106. In various embodiments, the FET can include a channel adjustment region at the surface of the substrate material in the body 106.

Further, in various embodiments, the FET 100 can include one or more electrically conducting field plates that are located near the drain, source, and/or gate regions. For example, a field plate can be located above at least part of each of the first and second drains 102A, 102B. The field plates can be either electrically isolated or connected the respective drains. For example, the field plates that are isolated can be biased independently of the voltages at the drains 102A, 102B, the gate 112, and/or the body dropdowns 114 to influence the operating parameters and behavior of the FET 100. For instance, a field plate can be used to reshape electric field distribution in the channel. This can be useful for reducing the channel value on the drain side of the gate edge, and thereby, increasing the breakdown voltage and reducing high-field trapping effect.

In accordance with a number of embodiments of the present disclosure, the plurality of body dropdowns 114 are electrically isolated from the gate 112. For example, the body dropdowns 114 can include an electrically insulating layer 113. In some embodyments, insulating material can be deposited and patterned within the body dropdowns 114.

In various embodiments, the FET can be constructed using a CMOS process as part of a device that includes integrated high voltage components designed support functionality for up to 40V. For example, the FET can be used as a power switch for charging purposes in mobile applications employing, for example, the USB-PD standard. The power switch can have a relatively high voltage (20-30V) on both sides with relatively low on resistance (10-100mOhm).

To achieve a low on resistance, the drift regions 104A, 104B can employ a Reduced Surface Field (RESURF) principle. The drains 102A, 102B can be formed in a variety of ways and can be used for regular asymmetrical extended drain devices (e.g., using local oxidation of silicon (LOCOS), shallow trench isolation or a dedicated (gate) oxide for the drain extension). Therefore, the FET construction can be made using a variety of different process where fully isolated regular extended drain devices are already available. The FET can be designed to insure that the drains of multiple fingers of the regular extended drain device are not shorted together via a deep/buried implant (e.g., by using an additional deep/buried p-type and n-type implant in the case of a p-type substrate or a silicon on insulator (SOI) substrate).

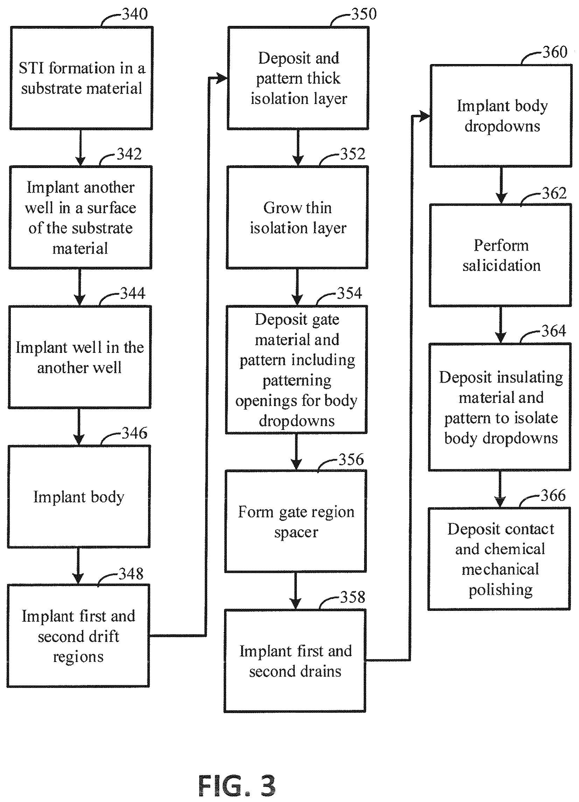

The various embodiments described herein may be combined in certain embodiments, and various aspects of individual embodiments may be implemented as separate embodiments. For instance, aspects of Figures 1A and 1B can be part of the apparatus described in Figure 2, and/or can both can be created with a process as described in Figure 3. For example, the FET illustrated by Figures 1A and 1B (and/or the FET illustrated by Figure 2) can be used with a variety of different types of devices. In some instances, the various techniques can be used in asymmetrical devices to improve device behavior. Example techniques that can be used in in connection with the FET embodiments described and illustrated herein can include additional or heavier implants in the body to increase device robustness by causing the parasitic bipolarity to be more difficult to trigger, drift region doping profile engineering (e.g., graded implants or slits) to optimize breakdown and resistance, field plates to reduce drift region resistance, and/or dedicated and/or stepped oxides (shallow trench isolation, LOCOS, recessed LOCOS, or deposited oxide) in the drift region, among other techniques.

For example, in various embodiments, the first drain 102A can include a first electrical contact (e.g., drain contact 230A illustrated by Figure 2) that is electrically connected to the first drain and the second drain 102B can include a second electrical contact *(e.g.,* drain contact 230B illustrated by Figure 2) that is electrically connected to the second drain. Further, the gate can include a third electrical contact (e.g., gate contacts 232 illustrated by Figure 2) that is electrically connected to the gate.

Further, in accordance with various embodiments, a FET can include fewer features and/or components than illustrated by Figures 1A and 1B. For example, a device embodiment can include a FET having a first drain, a second drain, a body, a gate, and a plurality of body dropdowns in the gate region. Further, rather than the well region and another well region various components can be formed directly within the substrate material, e.g., the respective first and second drain regions, body region, and gate regions can be at a surface of the substrate material.

FIG. 2 shows a top view and cross sectional view of a FET according to various embodiments of the present disclosure. As illustrated by the top view of the FET, the FET can include a first drain region 202A and a second drain region 202B that include drains that are both of a same donor type (e.g., a second donor type). A gate region 212 can include a plurality of body dropdowns 214 spaced along a width of the gate region 212. The gate region 212 can, in response to a gate voltage applied to a gate therein, create a channel between the first and the second drain regions 202A, 202B. In this context, the term "gate voltage" refers a voltage that is applied to the gate. The plurality of body dropdowns 214 can provide an electrical contact to the body 206 and be located within the gate region 212. In various embodiments, a bias circuit can be configured to provide a bias voltage to the electrical contact provided to the body 206 by the body dropdowns 214. For instance, the bias circuit can be configured to generate a bias voltage that suppresses the parasitic bipolar transistor that is present in the FET, as previously discussed. In some embodiments, the channel is segmented at the locations of the body dropdowns 214. A channel that is created under the influence of the gate region 212 may be suppressed, or prevented from forming at the locations of the body dropdowns 214. For instance, diffusion material that can be used to contact the body can disrupt the formation of the channel in the same area.

In accordance with various embodiments, the gate region 212 can include a number of other features and/or components. For example, the gate region 212 can include a gate 228 that can be connected to an external contact in the wiring layer through gate contacts 232 (*e.g.,* can connect other portions of the integrated circuit to the internal gate of the FET using vias). Similarly, the drain regions 202A, 202B can each include drain contacts 230A, 230B. The drain contacts 230A, 230B can also be used to connect the drains to an external contact in the wiring layer. In some embodiments, the contacts can be constructed using metal, silicide or other conductive materials.

As illustrated by the side views of the FET, the FET components can be located within a well 208 that is configured to isolate the first and second drift regions 204A, 204B from one another. For instance, the well region can have a different donor type than that of the drains. As depicted in FIG. 2, the well can contact the body 206 and extend below at least the first and second drift regions 204A, 204B and the body 206. Further, the body 206 and the gate 228 can be within the well 208. The FET, in various embodiments, can include another well 210 that separates the well 208 from the substrate 224.

The two side views represent cross sectional views of the top view at locations A and B. The upper side view, corresponding to A of the top view, does not show a body dropdown in the gate region 212. Thereby, in response to a gate voltage and a voltage different between the drains, current can conduct across the channel (e.g., created in the body 206) at the portion of the channel corresponding to A of the top view.

The second side view, corresponding to B of the top view, shows a body dropdown 214 in the gate region 212. The body dropdowns 214 can provide a bias voltage to the body 206. Further, in response to the gate voltage and the voltage provided to one of the drains, a channel might not form at the portion of the channel corresponding to B of the top view 220. That is, when the FET is otherwise enabled, the channel can remain inactive at a portion of the channel that corresponds to the body dropdowns 214 (e.g., due to a contact diffusion region at the inactive portion or due to the lack of a gate in the corresponding area).

FIG. 3 shows a flow diagram of an example process for forming a gate region of a FET according to various embodiments of the present disclosure. Forming the gate region of the FET can include gate material deposition and patterning, as discussed herein.

For example, the gate material can be patterned with a plurality of body dropdowns along the width of the gate material. The gate material can be deposited on insulating material. In various embodiments, the insulating material can form an electrically insulating layer. The insulating material can include, but is not necessarily limited to, oxides, nitrides, low-K dielectrics, and/or high-K dielectrics. For example, the electrically insulating layer can have different thicknesses, e.g., increased thickness at to the locations of the bodydrop downs. The electrically insulating layer can be deposited and/or grown on an implanted body and/or portions of a first and a second drift region of the FET. In some embodiments, the electrically insulating layer can extend over a portion of each of the first and second drain regions. Further, the electrically insulating layer can be created in multiple steps, each of which can be a thermal growth of an insulating material or a deposition of an insulating material. The gate material, in some embodiments, can be removed from a portion of the first and the second drain regions.

The patterning of the plurality of body dropdowns can be performed before or after depositing the gate material, in various embodiments. For example, openings in the gate region for the body dropdowns can be created at the same time as removing gate material from a portion of the first and the second drain regions. In other embodiments, the openings in the gate region for the body dropdowns can be created in a separate step. In some embodiments, the body dropdowns can be deposited in the openings. Further, an insulating material can be deposited and patterned within the body dropdowns. The insulating material can isolate the body dropdowns from the gate region. In various embodiments the insulating material in the body dropdowns can be etched. For example, the insulating material can be etched such that insulating material remains on the sidewalls of the body dropdowns only *(e.g.,* an anisotropic etch.)

In accordance with various embodiments, a process in which implantation and patterning of a variety of regions can be performed in a number of different orders and using a variety of patterning techniques. For example, beginning with a substrate material with or without a buried insulating layer, a well, another well, a body, a first and a second drains, a first and a second drift regions, the gate, the body dropdowns, and other implants can be implanted in a variety of orders. Further, insulating material can be deposited or grown, as previously discussed.

Figure 3 illustrates a particular embodiment of forming a FET. For example, at block 340, shallow trench isolation (STI) can be formed in a surface of a substrate material. STI formation, in various embodiments, includes removing portions of the substrate material prior to creation of the electrically insulating layers, as discussed further below. At block 342, a first well (*e.g.*, a deep well) can be implanted in a surface of the substrate material and, at block 344, a second well can be implanted in the deep well. At block 346, a body can be implanted in the second well, and, at block 348, the first and second drift regions can be implanted in the second well region.

At block 350, the thick electrically insulating layer *(e.g.,* the first insulating layer 107 illustrated by Figure 1A) can be deposited and patterned, and, at 352, the thin electrically insulating layer (e.g., insulating layer 103 illustrated by Figure 1B) can be grown. That is, as illustrated by Figure 3, the electrically insulating layer can be created in multiple steps and/or can include multiple layers of different thickness. The thicker layer can be located near the drift regions to allow for higher breakdown of the drift regions. In various embodiments, the insulating layer can be created by (local) growth or deposition followed by optional patterning.

At block 354, the gate material is deposited and patterned. The patterning of the gate material, in various embodiments, includes patterning openings for the plurality of body dropdowns. For example, the openings for the plurality of body dropdowns can be separated by a distance that is selected such that the electrical connection to the body region is sufficient to provide a bias voltage to the body region that is within a threshold of a supplied body voltage (*e*.*g*., as provided by a bias circuit of a device having the FET). At block 356, the gate region spacer can be formed.

At block 358, the first and second drains can be implanted. The first drain can be implanted in the first drift region and the second drain can be implanted in the second drift region, in various embodiments. The gate dropdowns, at block 360, can be implanted within the openings patterned in the gate region *(e.g.,* at block 354). The body dropdowns can provide an electrical contact to the body. At block 362, salicide process can be performed. Salicide can refer to forming electrical contacts between the semiconductor device and the supporting interconnect structure. For example, a salicide process can include reaction of a thin metal film with silicon in active regions of the device to form a metal silicide contact.

Insulating material, at block 364, can be deposited and patterned. For example, the insulating material can insulate the contacts, as well as, isolate the body dropdowns from the gate. At block 366, contacts can be deposited and chemical mechanical polishing can be performed.

As previously discussed, methods of forming a FET in accordance with the present disclosure are not limited to the embodiment illustrated by Figure 3. In various embodiments, the isolation between the gate and the body dropdowns can be created with the same process as isolation for the source and drain. In alternative embodiments, the isolation between the gate and body dropdowns can be created in separate steps, such as when the electrical contact of the body dropdowns are created in a self-aligned manner. Further, the openings in the gate region for the body dropdowns can be created in the same step that removes a portion of gate material from the first and second drain regions. Alternatively, the openings can be created in separate step from removing the portion of the gate material.
According to embodiments there is also provided a device comprising: a field-effect transistor (FET) having: a substrate material; a body at a surface of the substrate material and of a first doping type; a first drain at the surface of the substrate material and of a second doping type, that is different from the first doping type; a second drain at the surface of the substrate material and of the second doping type; a gate region having a gate that is located at the surface of the substrate material, that extends along a length of the gate region, and that is configured and arranged to create, in response to a gate voltage, a channel that is in the body, between the first and second drains, and along the length of the gate region; an electrically insulating layer between the body and the gate; and a plurality of body dropdowns in the gate region and spaced along a width of the gate region, each of the plurality of body dropdowns being electrically isolated from the gate and configured and arranged to provide an electrical contact to the body.
The FET may further comprise a first drift region that is configured to increase a breakdown voltage for the first drain.
The FET may further comprise a second drift region that is configured to increase a breakdown voltage for the second drain.
The FET may further comprise a well of the first doping type, wherein the body, the first and second drains, and the first and second drift regions are within the well, and wherein the well isolates the first drift region from the second drift region.
A second well may isolate the well of the first doping type from the substrate material.
The first doping type may include a p-type and the second doping type may include an n-type.
The first doping type may include an n-type and the second doping type may include a p-type.
The FET may further comprise a plurality of contact diffusion regions within the body, each of the contact diffusion regions below a corresponding body dropdown, wherein each contact diffusion region is doped at a higher level of the first doping type than the body.
According to an embodiment there is also provided a device comprising: a field-effect transistor (FET) having: a well of a first doping type; a first drain in the well and of a second doping type, that is different from the first doping type; a second drain in the well and of the second doping type; a body in the well and of the first doping type; the gate region in the well, having a gate that extends along a length of the gate region, and that is configured and arranged to create, in response to a gate voltage, a channel that is in the body and that is configured to conduct current between the first and the second drains, and along the length of the gate region; an electrically insulating layer between the body and the gate; and a plurality of body dropdowns spaced along a width of the gate region, each of the plurality of body dropdowns being electrically isolated from the gate and configured and arranged to provide an electrical contact to the body.
The electrically insulating layer between the body and the gate may extend to a portion of each of the first and the second drains.
The FET may further comprise at least one electrically conducting field plate located above at least one of the first drain, the second drain, and the gate, and
the at least one electrically conducting field plate is configured and arranged to influence an electrical behavior of the FET in response to an applied voltage.
The electrically insulating layer between the body and the gate may includes a first electrically insulating layer between the gate and a portion of the first and second drains, and a second electrically insulating layer between the gate and the body.
The first electrically insulating layer may be thicker than the second electrically insulating layer.

Various blocks, modules or other circuits may be implemented to carry out one or more of the operations and activities described herein and/or shown in the figures. In these contexts, a "block" (also sometimes "circuit", "logic circuitry", or "module") can be implemented using a circuit that carries out one or more of these or related operations/activities. In various embodiments, a hard-wired control block can be used to minimize the area for such an implementation in case a limited flexibility is sufficient. Alternatively and/or in addition, in certain of the above-discussed embodiments, one or more modules are discreet logic circuits or programmable logic circuits configured and arranged for implementing these operations/activities

Based upon the above discussion and illustrations, those skilled in the art will readily recognize that various modifications and changes may be made to the various embodiments without strictly following the exemplary embodiments and applications illustrated and described herein. For example, an apparatus can include different types of FET devices and configurations than illustrated by Figures 1 and 2. Such modifications do not depart from the true spirit and scope of various aspects of the invention, including aspects set forth in the claims.

## Claims

1. A device comprising:
a field-effect transistor (FET) that includes:
a first drain;
a second drain;
a body;
a gate region having a length, and configured and arranged to create, in response to a gate voltage, a channel that is in the body, between the first and second drains, and along the length of the gate region; and
a plurality of body dropdowns in the gate region and spaced along a width of the gate region, each of the plurality of body dropdowns configured and arranged to provide an electrical contact to the body.

2. The device of claim 1, wherein the body is of a first doping type, and the first and the second drains are of a second doping type that is different than the first doping type, and the FET further comprising:
a well of the first doping type, wherein the body, the first drain, and the second drain are within the well.

3. The device of claim 2, wherein the FET further comprises another well of the second doping type, wherein the well of the first doping type is within the another well.

4. The device of any one or more preceding claims, further comprising a bias circuit that is configured and arranged to provide a bias voltage to the plurality of body dropdowns, the bias voltage based on a voltage applied to the first drain.

5. The device of claim 4, wherein the device is configured to suppress parasitic bipolar turn on of the FET in response to the bias voltage.

6. The device of any one or more preceding claims , wherein the gate region is configured and arranged to create the channel with portions of the channel that are segmented by the body dropdowns.

7. The device of any one or more preceding claims , wherein the FET further comprises an electrically insulating layer between the body and the gate.
